# FASCICULE DE BREVET EUROPEEN

(11) **EP 0 788 233 B1**
(45) Date de publication et mention de la délivrance du brevet: **02.12.1998**
(21) Numéro de dépôt: 97460008.2
(22) Date de dépôt: 24.01.1997
(51) Int. Cl.: H03K 17/22

(54) **Circuit de remise à zéro**
Einschaltrücksetzschaltung
Power on reset circuit

(30) Priorité: 31.01.1996 FR 9601378
(43) Date de publication de la demande: 06.08.1997
(73) Titulaire: SGS-THOMSON MICROELECTRONICS S.A., 94250 Gentilly (FR)
(72) Inventeur: Naura, David, Domicilié au Cabinet Ballot-Schmit, 56100 Lorient (FR)
(74) Mandataire: Schmit, Christian Norbert Marie

(56) Documents cités:
- EP-A- 0 285 033
- EP-A- 0 573 965
- EP-A- 0 665 649
- US-A- 4 873 458
- US-A- 5 243 233

## Description

L'invention concerne un dispositif de neutralisation d'un circuit électronique au moment de sa mise sous tension ou de sa mise hors tension. Elle trouve plus particulièrement, bien que non exclusivement, son application dans le domaine des mémoires électriques programmables.

L'invention sera décrite dans le contexte des mémoires non volatiles programmables électriquement (EEPROM, Flash EPROM), sans qu'on puisse y voir une quelconque limitation de la portée de l'invention.

Lors de l'établissement de la tension d'alimentation dans une mémoire non volatile, toute opération d'écriture dans la mémoire doit être rendue impossible car on ne pourrait autrement garantir son résultat. Dans ce but, des dispositifs ont été développés pour neutraliser le fonctionnement de la mémoire pour les valeurs de tension d'alimentation inférieures à une valeur seuil. Cette valeur seuil est généralement déterminée en fonction de l'application du circuit électronique à neutraliser.

Les dispositifs de neutralisation connus d'une mémoire non volatile comprennent de manière classique un circuit de commande et un moyen inhibiteur du fonctionnement de la mémoire. Le circuit de commande délivre un signal de commande POR (Power On Reset) qui conditionne la sortie du moyen inhibiteur.

Le moyen inhibiteur transforme le signal de commande POR en un signal binaire. Lorsque la tension du signal de commande POR est nulle, le signal binaire est à un niveau haut. Pour toute valeur de la tension d'alimentation inférieure à la valeur seuil Vs, la sortie du moyen inhibiteur est à un niveau bas. Pendant le niveau haut du signal binaire, les opérations d'écriture dans la mémoire située en aval du moyen inhibiteur sont autorisées.

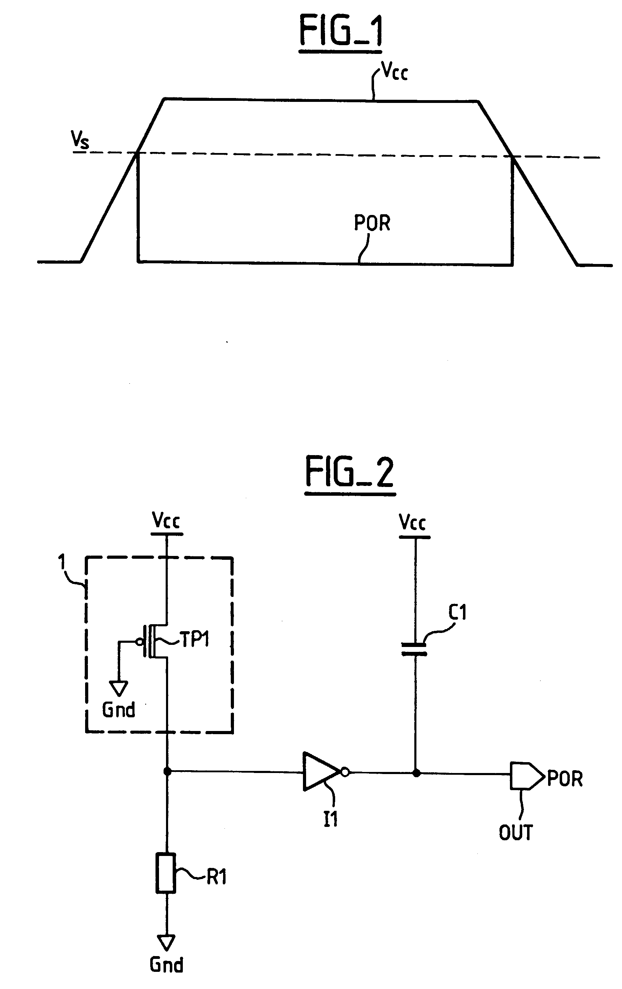

Le signal de commande POR est représenté à la figure 1. On constate qu'il se superpose à la tension d'alimentation Vcc tant que celle-ci reste inférieure à la valeur seuil Vs. Au-delà, la valeur de tension du signal de commande POR est nulle.

Classiquement, le moyen inhibiteur est une bascule dont la borne de "remise à zéro" reçoit le signal de commande POR et la borne de "mise à un" un signal de demande d'écriture. Le signal binaire issu du moyen inhibiteur sert à commander un générateur haute tension, lequel générateur de tension produit les tensions nécessaires pour la programmation et l'effacement des cellules mémoire. Quand la tension d'alimentation est inférieure à la valeur seuil Vs, le signal binaire est à un niveau bas et le générateur de tension est alors rendu inopérant. Toute opération d'écriture dans la mémoire est donc impossible.

Le circuit de commande est l'élément clé du dispositif de neutralisation. La figure 2 représente un circuit de commande connu. Il comporte un premier moyen 1 pour fixer la valeur seuil, relié par une entrée à une borne d'alimentation Vcc et par sa sortie à une borne de masse Gnd par l'intermédiaire d'une résistance R1. Ce moyen 1 devient passant lorsque la tension d'alimentation devient supérieure à une tension seuil propre, qui est dans ce cas égale à la valeur seuil Vs.

Dans l'exemple de la figure 2, Le moyen 1 est constitué d'un transistor natif de type P TP1 dont la source est reliée à la borne d'alimentation Vcc, le drain à la résistance R1 et la grille à la borne de masse Gnd. On rappelle qu'un transistor natif est un transistor n'ayant pas reçu d'implantation complémentaire dans son canal de conduction. Sa tension de seuil de conduction est de l'ordre de 0.2 volts pour un transistor de type N et de 1.3 volts pour un transistor de type P.

Le circuit de commande comporte en outre un inverseur I1 connecté entre la sortie du moyen 1 et une borne de sortie OUT par laquelle est délivré le signal de commande. Un condensateur de démarrage C1 est connecté entre la borne d'alimentation Vcc et la borne de sortie OUT pour obtenir le niveau de sortie attendu pendant le début de la montée de la tension d'alimentation.

Dans cet exemple, la valeur du seuil de conduction du transistor TP1 représente la tension seuil propre du moyen 1. Elle est aussi égale à la valeur seuil Vs.

Le fonctionnement d'un tel circuit de commande est bien connu de l'homme du métier. Sommairement, tant que la valeur de la tension d'alimentation Vcc est inférieure à la valeur du seuil de conduction du transistor TP1, la valeur de la tension à l'entrée de l'inverseur I1 est nulle. La borne de sortie OUT du dispositif délivre alors une tension égale à la tension d'alimentation.

Toutefois, il faut noter que le fonctionnement de l'inverseur I1 est perturbé au-dessous d'un certain niveau de la tension d'alimentation. En effet, les deux transistors constituant l'inverseur sont simultanément bloqués. Le condensateur de démarrage C1 permet d'imposer une tension égale à la tension d'alimentation à la sortie de l'inverseur I1.

Dès que la tension d'alimentation dépasse la tension seuil du transistor TP1, la tension à l'entrée de l'inverseur I1 devient à peu près égale à la tension d'alimentation. La tension sur la borne de sortie OUT du dispositif devient nulle. A l'inverse, lorsque la tension d'alimentation repasse en dessous de la tension seuil du transistor TP1, la tension sur la borne de sortie OUT est égale à la tension d'alimentation.

Ce type de dispositif a un inconvénient majeur: la valeur seuil du signal de commande peut varier de façon importante en raison de la dispersion des paramètres inhérents aux procédés de fabrication de transistors. Ces variations de la valeur seuil seront d'autant plus gênantes que la valeur nominale de la tension d'alimentation sera faible.

En effet, si on considère une mémoire fonctionnant avec une tension d'alimentation de 1.8 volts, il faut s'assurer que la tension seuil du transistor TP1 reste toujours inférieure à 1.8 volts. De préférence, on choisira dans ce cas une tension seuil égale à 1.5 volts, une telle valeur permettant de faire face aux faibles variations de la tension d'alimentation et de garantir le bon déroulement des opérations d'écriture dans la mémoire.

Or, dans la pratique, si l'on choisit de donner au transistor TP1 une tension de seuil dont la valeur nominale n'est que de 1,3 volts, il peut arriver que cette tension seuil réelle dépasse 1,8 volts dans des conditions d'utilisation défavorables telles que basse température, la différence entre tension de seuil réelle et tension de seuil nominale étant l'accumulation des écarts de valeur dus pour une part aux conditions de fabrication et pour une autre part aux conditions d'utilisation. On constate donc que l'on ne peut garantir le bon fonctionnement du dispositif.

Le but de l'invention est de réaliser un circuit de neutralisation plus fiable, notamment en ce qu'il sera beaucoup moins dépendant des variations dues aux conditions de fabrication dans les valeurs de ses composants.

Pour ce faire, on prévoit selon l'invention un moyen supplémentaire pour fixer la valeur seuil du signal de commande, monté en parallèle avec le moyen classique.

Ainsi, l'invention a pour objet un dispositif de neutralisation d'un circuit électronique destiné à empêcher toute opération dans le circuit électronique au moment de la mise sous tension ou au moment de la mise hors tension de ce dernier,
lequel dispositif de neutralisation comporte un circuit de commande et un moyen inhibiteur du fonctionnement du circuit électronique, ledit circuit de commande activant le moyen inhibiteur tant que la tension d'alimentation reste inférieure à une tension seuil ou lorsque la tension d'alimentation devient inférieure à ladite tension seuil, ledit circuit de commande comportant un premier moyen relié par une entrée à une borne d'alimentation et par sa sortie à une borne de masse par l'intermédiaire d'une résistance, ledit premier moyen comportant un transistor natif de type P devenant passant lorsque la tension d'alimentation devient supérieure à une première tension de seuil propre audit premier moyen, un premier inverseur connecté entre la sortie du premier moyen et une borne de sortie par laquelle est délivré un signal de commande du moyen inhibiteur,
et est caractérisé en ce que ledit circuit de commande comporte en outre un second moyen connecté entre la borne d'alimentation et l'entrée du premier inverseur, ledit second moyen devenant passant lorsque la tension d'alimentation devient supérieure à une seconde tension de seuil propre audit second moyen,
et en ce que le second moyen comporte un transistor natif de type N, la tension seuil dudit circuit de commande étant la plus faible desdites première et seconde tensions de seuil propres respectivement auxdits premier et second moyens.

Le transistor natif de type P du premier moyen et le transistor natif de type N du second moyen étant réalisés lors du même processus de fabrication, les écarts du seuil de conduction qu'ils présenteront avec leur valeur nominale seront de sens opposés.

Par conséquent, si par rapport à la valeur de seuil choisie, la tension seuil fixée par l'un desdits premier et second moyens est trop élevée, elle sera inférieure dans l'autre moyen, et c'est ce dernier qui sera opérant.

Dans un mode de réalisation préféré, le premier moyen est un transistor natif de type P dont la source est reliée à la borne d'alimentation, le drain à ladite résistance et à l'entrée dudit inverseur, et la grille à la borne de masse.

Le second moyen, quant à lui, peut être un transistor natif de type N connecté en série avec un transistor de type P.

D'autres caractéristiques et avantages de l'invention sont détaillés dans la description suivante, à titre d'exemple non limitatif, et en référence aux dessins annexés dans lesquels:
- la figure 1 représente un diagramme temporel du signal de commande POR issu d'un circuit de commande d'un circuit de neutralisation.
- la figure 2 représente un circuit de commande dans un circuit de neutralisation de l'état de la technique.
- la figure 3 représente un circuit de commande dans un circuit de neutralisation selon l'invention;
- la figure 4 représente un inverseur pour un circuit de commande selon l'invention.

Les figures 1, 2 faisant partie de l'état de la technique ont été préalablement décrites.

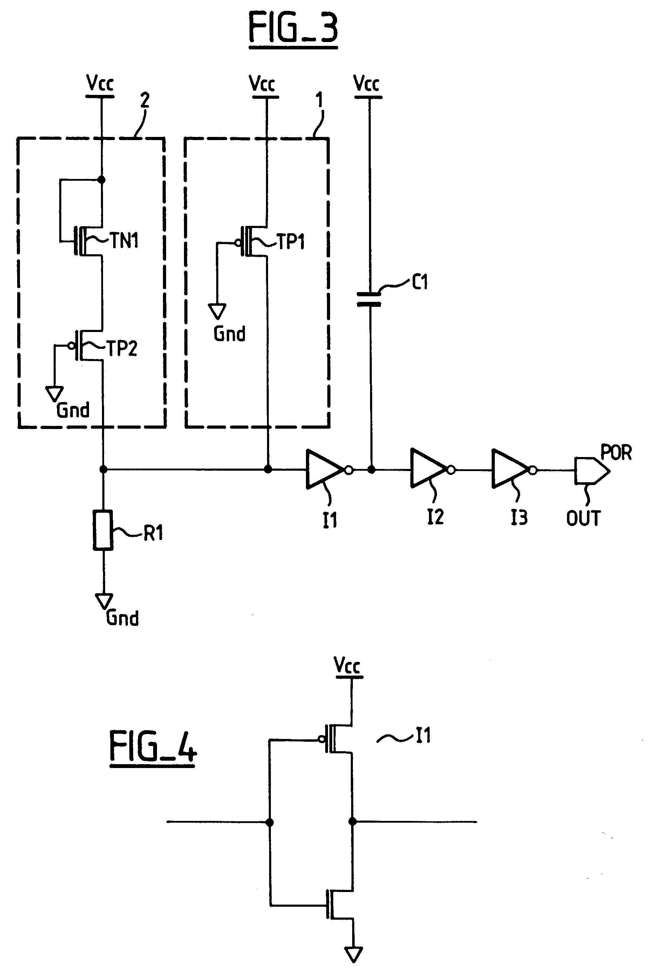

La figure 3 représente un schéma d'un circuit de commande selon l'invention.

Ce circuit de commande est un perfectionnement du circuit de commande de la figure 2 et sera décrit en regard de la figure 3.

Ce circuit comprend un moyen supplémentaire 2 connecté entre la borne d'alimentation Vcc et la sortie du moyen 1. Dans l'exemple de la figure 3, le moyen 2 est constitué d'un transistor natif de type N TN1 dont le drain et la grille de commande sont reliés à la borne d'alimentation Vcc et dont la source est reliée à la source d'un transistor de type P TP2. Par ailleurs, le drain du transistor TP2 est connecté à l'entrée de l'inverseur I1 et sa grille de commande est reliée à la borne de masse Gnd.

Les écarts entre les seuils de conduction réels du transistor natif de type N TN1 et du transistor de type P TP1 et leurs valeurs nominales, dues aux dispersions du procédé de fabrication, sont de sens opposés. La valeur seuil Vs du signal de commande POR sera fixée soit par le moyen 1, soit par le moyen 2. Cette valeur seuil Vs sera égale à la plus faible des tensions seuil desdits moyens 1 et 2.

Dès qu'un des deux moyens devient passant, la sortie de l'inverseur I1 change d'état et la tension du signal de commande POR devient nulle.

Selon un mode de réalisation préféré, deux inverseurs supplémentaires I2 et I3 sont rajoutés entre la sortie de l'inverseur I1 et la borne de sortie OUT. Ces deux inverseurs permettent de corriger les déformations éventuelles du signal de commande POR engendrées par le condensateur de démarrage C1 lorsque la tension sur la borne de sortie OUT est nulle.

Un second perfectionnement illustré à la figure 4 consiste à utiliser un inverseur I1 comportant un transistor natif de type P au lieu d'un transistor de type P classique et cela pour des raisons de consommation. En effet, le seuil de conduction d'un transistor natif de type P est supérieur à celui d'un transistor de type P classique. Un transistor natif se bloque donc plus rapidement qu'un transistor classique et permet ainsi de limiter la consommation.

En pratique, pour des écarts entre valeurs réelles et valeurs nominales des transistors natifs de type P et de type N correspondant aux conditions de fabrication les plus défavorables, et pour une température d'utilisation de -40°C, la valeur seuil obtenue pour un dispositif de l'invention a été de 1,6 volts, le dispositif étant alimenté en 1,8 volts.

Dans les mêmes conditions, la valeur seuil obtenue pour un dispositif tel que décrit ci-dessus à titre d'art antérieur aurait dépassé la valeur de la tension d'alimentation de 1,8 volts.

## Revendications

1. Dispositif de neutralisation d'un circuit électronique destiné à empêcher toute opération dans le circuit électronique au moment de la mise sous tension ou au moment de la mise hors tension de ce dernier,
lequel dispositif de neutralisation comporte un circuit de commande et un moyen inhibiteur du fonctionnement du circuit électronique, ledit circuit de commande activant le moyen inhibiteur tant que la tension d'alimentation reste inférieure à une tension seuil (Vs) ou lorsque la tension d'alimentation devient inférieure à ladite tension seuil (Vs), ledit circuit de commande comportant un premier moyen (1) relié par une entrée à une borne d'alimentation (Vcc) et par sa sortie à une borne de masse (Gnd) par l'intermédiaire d'une résistance (R1), ledit premier moyen (1) comportant un transistor natif de type P (TP1) devenant passant lorsque la tension d'alimentation devient supérieure à une première tension de seuil propre audit premier moyen (1), un premier inverseur (I1) connecté entre la sortie du premier moyen (1) et une borne de sortie (OUT) par laquelle est délivré un signal de commande (POR) du moyen inhibiteur,
et est caractérisé en ce que ledit circuit de commande comporte en outre un second moyen (2) connecté entre la borne d'alimentation (Vcc) et l'entrée du premier inverseur (I1), ledit second moyen (2) devenant passant lorsque la tension d'alimentation devient supérieure à une seconde tension de seuil propre audit second moyen (2),
et en ce que le second moyen (2) comporte un transistor natif de type N (TN1), la tension seuil (Vs) dudit circuit de commande étant la plus faible desdites première et seconde tensions de seuil propres respectivement auxdits premier et second moyens.

2. Dispositif de neutralisation selon la revendication 1, caractérisé en ce que le premier moyen (1) est un transistor natif de type P (TP1) dont la source est reliée à la borne d'alimentation (Vcc), le drain à la résistance (R1) et la grille à la borne de masse (Gnd).

3. Dispositif de neutralisation selon l'une des revendications 1 ou 2, caractérisé en ce que le second moyen (2) est un transistor natif de type N (TN1) connecté en série avec un transistor de type P (TP2), le drain et la grille du transistor natif de type N (TN1) étant reliée à la borne d'alimentation (Vcc), le drain du transistor de type P (TP2) étant relié à la résistance (R1) et sa grille à la borne de masse (Gnd).

4. Dispositif de neutralisation selon l'une des revendications 1 à 3, caractérisé en ce que ledit premier inverseur (I1) comporte un transistor de type P, lequel est natif.

5. Dispositif de neutralisation selon l'une des revendications 1 à 4, caractérisé en ce que deux inverseurs supplémentaires (I2,I3) sont insérés entre la sortie du premier inverseur (I1) et la borne de sortie (OUT).

## Patentansprüche

1. Vorrichtung zum Neutralisieren einer elektrischen Schaltung, die dann jede Operation der elektrischen Schaltung unterbindet, wenn Spannung angelegt oder abgeschaltet wird,
wobei die Entkopplungsvorrichtung eine Steuerschaltung und eine Einrichtung enthält, die den Betrieb der elektronischen Schaltung hemmt, wobei die Steuerschaltung eine Hemmeinrichtung aktiviert, sobald die Versorgungsspannung unterhalb einer Schwellspannung (Vs) bleibt, oder sobald die Versorgungsspannung geringer als die Schwellspannung Vs wird, wobei die Steuerschaltung eine erste Einrichtung (1) aufweist, die an einem Eingang an eine Versorgungsspannung (Vcc) und an ihrem Ausgang über einen Widerstand (R1) an Masse angeschlossen ist, wobei die erste Einrichtung (1) einen eigenleitenden Transistor vom Typ P (TP1) aufweist, der durchgängig wird, wenn die Versorgungsspannung größer wird als eine ersten Schwellspannung der ersten Einrichtung (1), wobei ein erster Inverter (I1) zwischen dem Ausgang der ersten Einrichtung (1) und einem Ausgang (OUT) angeschlossen ist, durch den ein Steuersignal (POR) der Hemmeinrichtung übergeben wird,
**dadurch gekennzeichnet,** daß
die Steuerschaltung weiterhin eine zweite Einrichtung (2) aufweist, die zwischen die Versorgungsspannung (Vcc) und den Eingang des ersten Inverters (I1) geschaltet ist, wobei die zweite Einrichtung (2) durchgängig wird, wenn die Versorgungsspannung größer als eine zweite Schwellspannung der zweiten Einrichtung (2) wird, und
die zweite Einrichtung einen eigenleitenden Transistor vom Typ N (TN1) enthält, wobei die Schwellspannung der Steuerschaltung kleiner als die erste und zweite Schwellspannung der jeweils ersten und zweiten Einrichtung ist.

2. Vorrichtung nach Anspruch 1, dadurch gekennzeichnet, daß die erste Einrichtung ein eigenleitender Transistor vom Typ P (TP1) ist, dessen Source-Elektrode an die Versorgungsspannung (Vcc), dessen Drain-Elektrode an den Widerstand (R1) und dessen Gate-Elektrode an Masse (Gnd) angeschlossen ist.

3. Vorrichtung nach einem der Ansprüche 1 oder 2, dadurch gekennzeichnet, daß die zweite Einrichtung ein eigenleitender Transistor vom Typ N (TN1) ist, der in Serie zu einem Transistor vom Typ P (TP2) geschaltet ist, wobei die Drain-Elektrode und die Gate-Elektrode des eigenleitenden Transistors vom Typ N (TN1) an die Versorgungsspannung Vcc angeschlossen sind, und wobei die Drain-Elektrode des Transistors vom Typ P (TP2) an den Widerstand R1 und die Gate-Elektrode an Masse Gnd angeschlossen sind.

4. Vorrichtung nach einem der Ansprüche 1 bis 3, dadurch gekennzeichnet, daß der erste Inverter (I1) einen eigenleitenden Transistor vom Typ P enthält.

5. Vorrichtung nach einem der Ansprüche 1 bis 4, dadurch gekennzeichnet, daß zwei zusätzliche Inverter (I2, I3) zwischen dem Ausgang des ersten Inverters (I1) und dem Ausgang (OUT) eingefügt sind.

## Claims

1. Device for neutralising an electronic circuit, intended to prevent any operation in the electronic circuit at the moment when the latter is powered up or switched off,
which neutralisation device has a control circuit and a means of inhibiting the functioning of the electronic circuit, the said control circuit activating the inhibiting means as long as the supply voltage remains below a threshold voltage (Vs) or when the supply voltage becomes less than the said threshold voltage (Vs), the said control circuit having a first means (1) connected by an input to a supply terminal (Vcc) and by its output to an earth terminal (Gnd) by means of a resistor (R1), the said first means (1) having a p-type native transistor (TP1) becoming conducting when the supply voltage becomes greater than a first threshold voltage peculiar to the said first means (1), a first inverter gate (I1) connected between the output of the first means (1) and an output terminal (OUT) by means of which a control signal (POR) for the inhibiting means is delivered,
and is characterised in that the said control circuit also has a second means (2) connected between the supply terminal (Vcc) and the input of the first inverter gate (I1), the said second means (2) becoming conducting when the supply voltage becomes greater than a second threshold voltage peculiar to the said second means (2),
and in that the second means (2) has an n-type native transistor (TN1), the threshold voltage (Vs) of the said control circuit being the lowest of the said first and second threshold voltages peculiar respectively to the said first and second means.

2. Neutralisation device according to Claim 1, characterised in that the first means (1) is a p-type native transistor (TP1) whose source is connected to the supply terminal (Vcc), whose drain is connected to the resistor (R1) and whose gate is connected to the earth terminal (Gnd).

3. Neutralisation device according to one of Claims 1 or 2, characterised in that the second means (2) is an n-type native transistor (TN1) connected in series with a p-type transistor (TP2), the drain and gate of the n-type native transistor (TN1) being connected to the supply terminal (Vcc), the drain of the p-type transistor (TP2) being connected to the resistor (R1) and its gate to the earth terminal (Gnd).

4. Neutralisation device according to one of Claims 1 to 3, characterised in that the said inverter gate (I1) has a p-type transistor which is native.

5. Neutralisation device according to one of Claims 1 to 4, characterised in that two additional inverter gates (I2, I3) are inserted between the output of the first inverter gate (I1) and the output terminal (OUT).
